# EUROPEAN PATENT SPECIFICATION

(11) **EP 2 821 930 B1**
(45) Date of publication and mention of the grant of the patent: **30.08.2017**
(21) Application number: 13866490.9
(22) Date of filing: 03.07.2013
(51) Int. Cl.: B63B 49/00, G06F 17/50, G06T 17/05

(54) **AIDS-TO-NAVIGATION SIMULATOR SYSTEM**
NAVIGATIONSHILFENSIMULATORSYSTEM
SYSTÈME DE SIMULATION D'AIDES À LA NAVIGATION

(30) Priority: 29.03.2013 KR 20130034193
(43) Date of publication of application: 07.01.2015
(73) Proprietor: Korea Institute Of Ocean Science & Technology, Ansan-si, Gyeonggi-do 426-744 (KR); Korea Association of Aids to Navigation, Seoul 153-803 (KR)
(72) Inventor: PARK, Se Kil, Daejeon, 305-343 (KR); GONG, In Young, Daejeon, 305-500 (KR); KIM, Yeon Gyu, Daejeon, 302-831 (KR); KIM, Hye Jin, Daejeon, 305-500 (KR); YANG, Young Hoon, Daejeon, 302-765 (KR); KANG, Sung Bok, Gyeonggi-do, 435-757 (KR); KIM, Jong Uk, Seoul, 122-817 (KR); HAN, Ju Seop, Gyeonggi-do, 422-060, (KR); JEE, Hyoung Min, Daejeon, 302-741 (KR)
(74) Representative: Thum, Bernhard
(86) International application number: PCT/KR2013/005881
(87) International publication number: WO 2014/157774

(56) References cited:
- KR-A- 20090 002 953
- KR-A- 20090 093 230
- KR-A- 20110 114 077
- KR-A- 20110 116 842
- KR-A- 20120 047 649
- Kazuhiko Hasegawa ET AL: "AN INTELLIGENT SHIP HANDLING SIMULATOR WITH AUTOMATIC COLLISION AVOIDANCE FUNCTION OF TARGET SHIPS", INSLC 17 - International Navigation Simulator Lecturers' Conference, Rostock-Warnemünde 2012, 7 September 2012 (2012-09-07), pages 1-10, XP055268608, Retrieved from the Internet: URL:http://www.naoe.eng.osaka-u.ac.jp/~has e/cv/papers/140.pdf [retrieved on 2016-04-26]
- M Numano ET AL: "Sea Traffic Simulation and its Visualization in Multi-PC System", Proceedings of International Congress on Modelling and Simulation (MODSIM) 2001, pp. 2093-2098, Canberra, Australia, December 2001, 31 December 2001 (2001-12-31), pages 1-6, XP55268602, Retrieved from the Internet: URL:https://www.nmri.go.jp/ocean-risk/sys- anlg0/members/hiroko/papers/Seatras_MODSIM 01.pdf [retrieved on 2016-04-26]

## Description

### BACKGROUND OF THE INVENTION

### 1. FIELD OF THE INVENTION

The present invention relates to an aids-to-navigation (AtoN) simulator system, and in particular relate to allowing an AtoN facility to be freely disposed in advance in a virtual space reproduced in the same condition with a real sea area, before installing the AtoN facility at the real sea area, by utilizing a simulation technology.

### 2. BACKGROUND ART

In the publication Kazuhiko Hasegawa, Junji Fukuto, Rina Miyake and Masahiro Yamazaki "AN INTELLIGENT SHIP HANDLING SIMULATOR WITH AUTOMATIC COLLISION AVOIDANCE FUNCTION OF TARGET SHIPS" INSLC 17 - International Navigation Simulator Lecturers' Conference Rostock-Warnemuende 2012 there is disclosed a ship handling simulator in which a ship being piloted by the user is presented with "target" ships to avoid which have automated collision avoidance strategies programmed into them, so that the target ships are moved so as to avoid the user's ship. This is an improvement over previous ship simulators in which the target ships just followed a course without interaction with the user's ship. A more realistic ship simulator is thus provided. The simulated environment also includes navigational aids and realistic scenery.

Navigation aids (i.e. aids-to-navigation) are kinds of facilities for securing safety on sea routs, which more specifically mean maritime traffic safety facilities such as light houses, light beacons, standing beacons, buoys, mist signaling cites, etc., which act as indices for ships sailing harbors, bays, channels, and other countries' inland waters, territorial waters, and exclusive economical zones, by means of lantern light, shapes, colors, sounds, radio waves, etc.

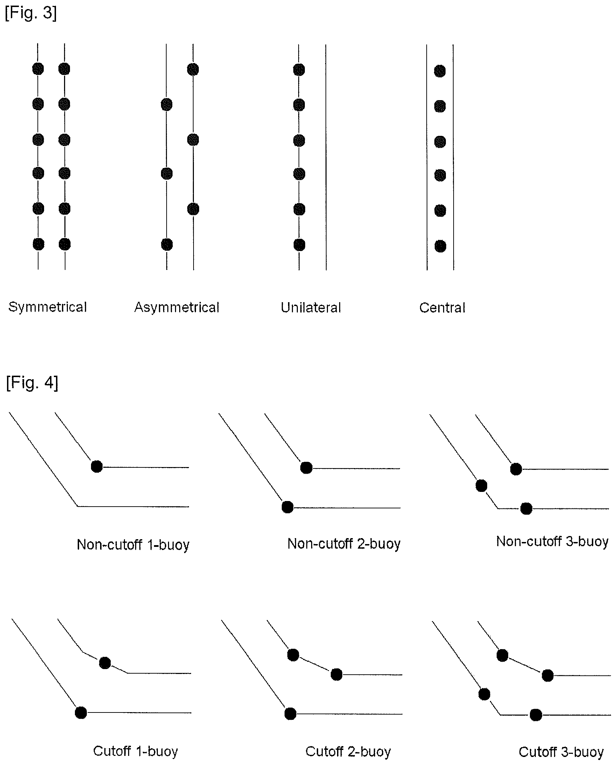

Those navigation aids are usually demanded to be disposed and managed in consideration of ship traffic flow, and maritime/overland geographical features. Indisposing the navigation aids, it has been generalized to arrange them in the same interval for a strait course (see Fig. 3) and, for a curved course, arrange them in number of 3 or 4 on the apex of the curved route (see Fig. 4).

Disposition and management with such navigation aids are still conditioned to experientially obtain data about their optimum types and number, and arrangement ideas, for maximizing their installment effects, just by way of many times of repeated installments and modifications. For instance, after once installing navigation aids along a route at sea, whether to continue the installment or modify the disposition could be determined when there was a problem.

However, the installment and modification with navigation aids are inevitably accompanied with large structures, causing much difficulty and high cost in operation and thereby increasing a burden of service. Furthermore, additional burdens are actually weighted down on work as there are frequent affairs of rearranging the navigation aids due to various shipping risks arising after installing them. Therefore, regarding such circumstances, it may be necessary to prepare an effective way for disposition and management of navigation aids.

### SUMMARY OF THE INVENTION

Embodiments of the present invention are directed to provide an aids-to-navigation (hereinafter will be referred to as AtoN) simulator system allowing an AtoN facility to be freely disposed in advance in a virtual space reproduced in the same condition with a real sea area, before installing an AtoN at the real sea area, by utilizing a simulation technology.

In one embodiment, there is provided a simulator system according to claim 1.

### BRIEF DESCRIPTION OF THE DRAWINGS

These and other features, aspects and advantages of the present invention will become better understood with regard to the following description, appended claims and accompanying drawings where:
Fig. 1 is a schematic view illustrating an AtoN simulator system according to embodiments of the present invention;
Fig. 2 illustrates a configuration of the AtoN simulator system according to embodiments of the present invention;
Fig. 3 illustrates a general pattern of disposing an AtoN for a straight course; and
Fig. 4 illustrates a general pattern of disposing an AtoN for a curved course.

### DETAILED DESCRIPTION OF THE INVENTION

The invention relates to a method and apparatus for reducing interference in a positioning system. In the following description, numerous specific details are set forth to provide a more thorough description of embodiments of the invention. It will be apparent, however, to one skilled in the art, that the invention may be practiced without these specific details. In other instances, well known features have not been described in detail so as not to obscure the invention.
Now hereinafter embodiments of the present invention will be described in detail.

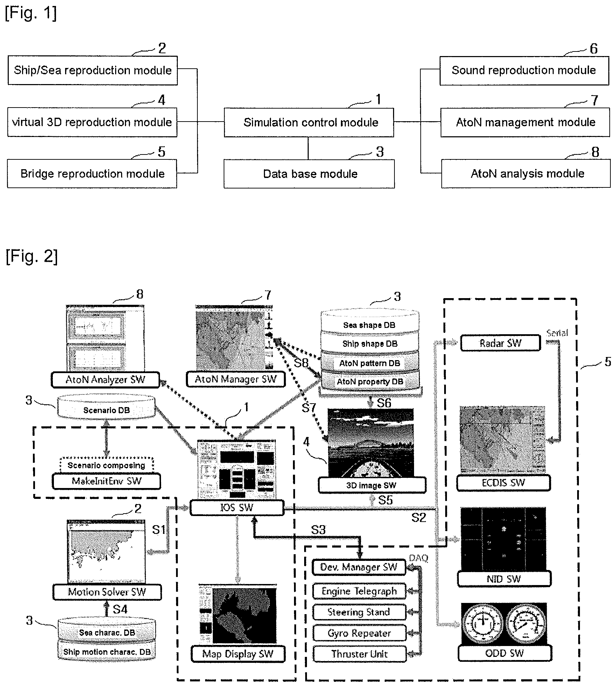

Fig. 1 is a schematic view illustrating an AtoN simulator system according to embodiments of the present invention. Fig. 2 illustrates a configuration of the AtoN simulator system according to an embodiment of the present invention, showing inter-operative relations among software tools and modules for driving the modules.

This AtoN simulator system according to the present invention is configured to allow an AtoN facility to be freely disposed in advance in a virtual space reproduced in the same condition with a real sea area, before installing the AtoN facility at the real sea area, by utilizing a simulation technology.

By way of embodiments of the present invention, a variety of disposition plans can be practiced to find an optimum AtoN arrangement through evaluation in the dimensions of quantification with reference to information about shipping courses, AtoN types, and overland backlight (e.g. downtown light), respective to the disposition plans, as well as to actually operate a ship in a virtual space with the AtoN arrangement, allowing qualitative analysis for shipping safety and so on in advance.

The present invention is therefore directed to reducing costs and time for AtoN disposition and management by building an AtoN simulator system capable of verifying a degree of optimization for AtoN arrangement in quantitative and qualitative modes.

In order to achieve the goal of the present invention, an AtoN simulator system is configured to include a simulation control module 1, a ship/sea reproduction module 2, a database module 3, a virtual 3D reproduction module 4, a bridge reproduction module 5, a sound reproduction module 6, an AtoN management module 7, and an AtoN analysis module 8. Hereinafter functions and interrelations of the components of the AtoN simulator system will be described in detail.

### 1. Simulation control module

The simulation control module 1 is configured to execute general management functions over preparation and beginning, monitoring and control (regulation), and termination of the simulation.

The preparation of the simulation is to set an initial location and a course of a virtual ship, and the beginning includes processes of selecting a sea area for AtoN disposition and a ship to be used for verification, and setting initial environmental conditions such as winds and waves, weather conditions, and time.

After beginning the simulation, the simulation control module 1 operates to regulate an overall shipping state of the ship. During this, the simulation control module 1 executes control operations of monitoring and regulating environmental information such as winds and waves, changing weather conditions and time, and adjusting states of propulsion and steering.

The simulation control module 1 transfers information, which is involved in execution of the simulation until the termination, to the database module 2 so as to make the information recorded in the database module 2. The information recorded (stored) in the database module 3, although variable by intention for system configuration and application, generally includes data about shipping, environments of a target sea area, weather and time, and others necessary for quantitative analysis of AtoN.

The simulation control module 1 transfers current state values, such as ship locations and wave heights, to the ship/sea reproduction module 2, receives and stores the next state values (calculated from the ship/sea reproduction module 2) (S1 of Fig. 2), and then transfers the next state values to the virtual 3D reproduction module 4, the bridge reproduction module 5, and the sound reproduction module 6 so as to allow the simulation to be enabled with synchronization (S2, S3 and S5 of Fig. 2).

### 2. Ship/sea reproduction module

The ship/sea reproduction module 2 is configured to calculate and return the next state values toward the simulation control module 1 after receiving current state values, such as ship locations and wave heights, from the simulation control module 1. During this, for reproducing ship motion characteristics, the calculation is conducted with ship dimensions data about length, width, draft of the target ship, which are invoked from the database module 3 (S4 of Fig. 2).

### 3. Database module

The database module 3 is configured to store information about ship and sea area, shape and characteristics of AtoN, and simulation execution. This database module 3 may work in a variety of types in accordance with a kind of information stored therein. For example, it may work as a scenario database storing scenarios for simulation, a sea-area state database storing states of sea areas where virtual ships will operate, a sea-area shape database storing shapes of sea areas where virtual ships will operate, a ship motion characteristics database storing motion characteristics while virtual ships are operating, a ship shape database storing shapes of virtual ships, an AtoN property database storing properties of AtoNs, and an AtoN pattern database storing patterns of AtoNs (see Fig. 2).

### 4. Virtual 3D reproduction module

The virtual 3D reproduction module 4 is configured to visibly show information about ships and environments, weather conditions and time which are provided from the simulation control module 1 (S5 of Fig. 2). During this, the virtual 3D reproduction module 4 visibly shows information about shapes of sea area and ship and properties of AtoN which are received from the database module 3 (S6 of Fig. 2), along with information about AtoN disposition which is received from the AtoN management module 7 (S7 of Fig. 2).

### 5. Bridge reproduction module

The bridge reproduction module 5 is configured to reproduce devices in a bridge of ship, such as steerage, engine telegraph, radar, shipping information display, and so on (see Fig. 2). The bridge reproduction module 5 receives information necessary for reproducing inherent functions of steerage, engine telegraph, radar, shipping information display and so on, and then similarly emulates their practical ones (S2 of Fig. 2). During this, the bridge reproduction module 5 also functions to transfer steering and engine instruction values toward the simulation control module 1 in relevance with the devices used for ship control such as steerage and engine telegraph (S3 of Fig. 2).

### 6. Sound reproduction module

The sound reproduction module 6 is configured to reproduce information, which is relevant to sound reproduction, from the simulation control module 6. This information about sound reproduction means data of engine output states, atmospheric phenomena (noises of wind, rain and thunder), locations of ships and helicopters passing by around the target sea area.

### 7. AtoN management module

The AtoN management module 7 is configured to execute functions of adding, editing and deleting AtoNs, and disposing new AtoNs.

The functions of adding, editing and deleting AtoNs are accomplished by executing instructions for storing, correcting and deleting AtoN properties through the database module 3 (S8 of Fig. 2). The AtoN properties mean practical AtoNs' property values by kinds, such as the total size of AtoN, and sizes and colors, attenuation rates, flickering periods, of lanterns, and so on.

The function of disposing AtoNs is accomplished by positioning an AtoN on an electronic nautical chart or a nautical chart, which is made based on the electronic chart, through the AtoN management module 7. This function of disposition is synchronized and visibly shown by way of the virtual 3D reproduction module 4 (S7 of Fig. 2).

Additionally, the AtoN management module 7 enables to operate a ship by using a virtual shipping function with a virtual ship anytime while disposing an AtoN. As this operation is also synchronized and visibly shown through the virtual 3D reproduction module 4 (S7 of Fig. 2), a manager is able to conduct visual verification for shipping safety according to a result of AtoN disposition, by way of the shipping operation with a disposed AtoN, through a visible screen, and then subsequently evaluate the result in qualitative mode.

Additionally, the AtoN management module 7 further includes a function of outputting catalogues and nautical charts for disposition results so as to help analyzing and planning the AtoN disposition.

### 8. AtoN analysis module

The AtoN analysis module 8 is configured to execute a function of quantifying AtoN disposition results by locations (function of analyzing positional disposition results) or by courses (function of analyzing coursed disposition results).

The function of analyzing positional disposition results is to quantify optimized disposition points for AtoNs at current ship locations while the AtoN analysis module 8 is conducting a virtual shipping operation through the simulation control module 1 and the AtoN management module 7. In other words, analyzing positional disposition results is to dynamically quantify disposition results by AtoNs during the simulation, focusing on the analysis for the disposition results by AtoNs at the current ship locations.

The function of analyzing coursed disposition results is to quantify afterward optimized disposition points by AtoNs for virtual shipping courses corresponding thereto after the AtoN analysis module 8 terminates the virtual shipping operation through the simulation control module 1 and the AtoN management module 7, including quantification by accumulation with the optimized disposition points by AtoNs for different virtual shipping courses. In other words, analyzing coursed disposition results is to quantify disposition results by AtoNs after completely terminating the simulation, focusing on the synthetic analysis for the disposition results by AtoNs on a course along which the ship has moved until now.

With regard to the positional or coursed disposition result analysis by the AtoN analysis module 8, a user is able to set a new location and course of the ship through the simulation control module 1 before or during the simulation, and even make a velocity of the ship higher or lower than a practical one.

The AtoN analysis module 8 transfers such optimized disposition points by AtoNs, which is quantified, to the AtoN management module 7. Then the AtoN management module 7 is allowed to use the optimized disposition points in determining an optimum position of disposition.

### Embodiments

Fig. 2 illustrates a configuration of the AtoN simulator system according to embodiments of the present invention, showing inter-operative relations among software tools and modules for driving the modules. On the other hand, the software tools mentioned in the embodiment relevant to Fig. 2 are exemplarily adopted and their composition may be diversified depending on target ships, costs and so forth.

In the embodiments of the present invention, a software tool for driving the simulation control module 1 may include Instruction Operation Station (IOS), Map Display, MakeInitEnv, and so on. IOS is for operating the simulator, and setting and regulating the simulation. Map Display is for displaying 2D maps and controlling rudders. MakeInitEnv is for selecting sea areas, and managing ship locations/courses.

Additionally, the embodiments of the present invention may adopt Motion Solver as a software tool for driving the ship/sea reproduction module 2. Motion Solver functions to reproduce motion characteristics of ships.

Additionally, the embodiments of the present invention divisionally use the database module 3 with a scenario database storing scenarios for the simulation, a sea-area state database storing states of sea areas where virtual ships will operate, a sea-area shape database storing shapes of sea areas where virtual ships will operate, a ship motion characteristics database storing motion characteristics while virtual ships are operating, a ship shape database storing shapes of virtual ships, an AtoN property database storing properties of AtoNs, and an AtoN pattern database storing patterns of AtoNs.

Additionally, the embodiments of the present invention may employ a 3D image software tool for driving the virtual 3D reproduction module 4. Such a 3D image software functions to generate 3D images for current states of the simulation.

Additionally, for driving the bridge reproduction module 5, the embodiments of the present invention may adopt various software tools such as Device Manager, Radar, Electronic Chart Display and Information System (ECDIS), Navigation Information Display (NID), Overhead Data Display (ODD), and so on. Device Manager is for controlling and inputting/outputting data to several navigation devices (engine telegraph, steering stand, gyro repeater, thruster unit, etc.). Radar is a radar emulator for assisting Automatic Radar Plotting Aids (ARPA). ECDIS is for displaying nautical charts observing the standard S-57/S-52. NID is for exhibiting information about states of engine controller and steerage, wind direction, wind velocity, water depth, etc. at the center of the bridge. ODD is for exhibiting information about wind direction, wind velocity, ship velocity, rudder angle, revolutions per minute (RPM), etc. at the top of the bridge.

Additionally, the embodiments of the present invention employ AtoN Manager as a software tool for driving the AtoN management module 7. AtoN Manager functions to manage an AtoN database such as AtoN property database or AtoN shape database.

Additionally, in the embodiments of the present invention, a software tool for driving the AtoN analysis module 8 may be used with AtoN Analyzer. AtoN Analyzer functions to analyze AtoN disposition results.

In view of the above, it will be seen that the several objects of the invention are achieved and other advantageous results obtained. For disposition and management of an AtoN, it is practicable to dispose and design in advance the AtoN through a simulator before installing and modifying the AtoN with high difficulty and costs in a real sea area, reducing a term and costs for service. Moreover, preliminarily confirming the pertinence to disposition and design of AtoN to be installed in a real sea area, by way of the simulation, contributes to prevent marine casualties from being caused due to incongruence of the AtoN.

As various changes can be made in the above constructions without departing from the scope of the invention, it is intended that all matter contained in the above description or shown in the accompanying drawings shall be interpreted as illustrative and not in a limiting sense. The invention is defined by the claims and their full scope of equivalents.

## Claims

1. A simulator system for determining optimum positions of navigation aids for ships, allowing a navigation aid to be freely disposed in advance in a virtual space reproduced in the same condition as a real sea area, before installing the navigation aid in the real sea area, by utilizing a simulation technology, the simulator system comprising:
a simulation control module (1) configured to execute general management over preparation, beginning, regulation and termination for the simulation;
a ship/sea reproduction module (2) configured to calculate the next state values from current state values, which include information about ship locations and wave heights, provided from the simulation control module (1) and return a result of the calculation to the simulation control module (1);
a database module (3) configured to store information about ships and sea areas, navigation aid shapes and characteristics, and simulation executions;
a virtual three-dimensional reproduction module (4) configured to show information about ships, environments, weather conditions, and time which are provided from the simulation control module (1);
a bridge reproduction module (5) configured to reproduce steerage, engine telegraph, radar, and shipping characteristics;
a sound reproduction module (6) configured to reproduce sound from information about the sound effect reproduction which is provided from the simulation control module (1);
a navigation aid management module (7) configured to add, edit, delete, and dispose a navigation aid in the simulation; and
a navigation aid analysis module (8) configured to quantify navigation aid disposition results by locations, as a function of analyzing positional disposition results, or by courses, as a function of analyzing coursed disposition results,
wherein the navigation aid analysis module is configured to quantify optimized disposition points for navigation aids at current ship locations during a virtual shipping operation in analyzing the positional disposition results, and/or
wherein the navigation aid analysis module is configured to quantify optimized disposition points by navigation aids for correspondent virtual shipping courses, after a virtual shipping operation, in analyzing the coursed disposition results, and
wherein the navigation aid analysis module is configured to transfer the optimized disposition points by navigation aids, which is quantified, to the navigation aid management module, allowing the navigation aid management module to use the optimized disposition points in determining an optimum position for a navigation aid.

2. The simulator system according to claim 1, wherein the simulation control module (1) is configured to set initial locations and shipping courses of virtual ships in executing preparing the simulation.

3. The simulator system according to claim 1, wherein the simulation control module (1) is configured to select a sea area for navigation aid disposition and a ship to be used for verification, and set initial environmental conditions such as winds and waves, weather conditions, and time in beginning the simulation; and/or
wherein the simulation control module (1) is configured to regulate an overall shipping state of the ship, during which the simulation control module (1) executes control operations of monitoring and regulating environmental information such as winds and waves, changing weather conditions and time, and adjusting states of propulsion and steering, in controlling the simulation.

4. The simulator system according to claim 1, wherein the simulation control module (1) is configured to transfer information, which is involved in execution of the simulation until termination, to the database module (3) so as to make the information recorded in the database module (3) in terminating the simulation; and
wherein, optionally, the database module (3) is configured to store information about shipping operation of a ship, environments of a target sea area, weather and time, and quantitative analysis for navigation aids.

5. The simulator system according to claim 1, wherein the simulation control module (1) is configured to transfer current state values, such as ship locations and wave heights, to the ship/sea reproduction module (2), receive and store the next state values from the ship/sea reproduction module (2), and then transfer the next state values to the virtual three-dimensional reproduction module (4), the bridge reproduction module (5), and the sound reproduction module (6) so as to allow the simulation to be enabled with synchronization.

6. The simulator system according to claim 1, wherein the ship/sea reproduction module (2) is configured to invoke ship dimensions data about length, width, draft of a ship from the database module (3), for reproducing ship motion characteristics, in calculating the next state values toward the simulation control module (1) after receiving current state values, such as ship locations and wave heights, from the simulation control module (1).

7. The simulator system according to claim 1, wherein the database module (3) is configured to divisionally work with a multiplicity of databases in accordance with a type of information stored in the database module (3); and
wherein, optionally, the database module (3) is configured to divisionally work as a scenario database storing scenarios for the simulation, a sea-area state database storing states of sea areas where virtual ships operate, a sea-area shape database storing shapes of sea areas where virtual ships operate, a ship motion characteristics database storing motion characteristics while virtual ships are operating, a ship shape database storing shapes of virtual ships, a navigation aid property database storing properties of navigation aids, and a navigation aid pattern database storing patterns of navigation aids.

8. The simulator system according to claim 1, wherein the virtual three-dimensional reproduction module (4) is configured to visibly show information about shapes of sea areas and ships, and properties of navigation aids, which is received from the database module (3), along with information about navigation aid disposition which is received from the navigation aid management module (7), in visibly showing information about ships and environments, weather conditions and time which are provided from the simulation control module (1).

9. The simulator system according to claim 1, wherein the bridge reproduction module (5) is configured to emulate a bridge of ship after receiving information necessary for reproducing inherent functions of steerage, engine telegraph, radar, shipping information display; and
wherein, optionally, the bridge reproduction module (5) is configured to transfer steering instruction values applied to the steerage, and engine instruction values applied to the engine telegraph toward the simulation control module (1).

10. The simulator system according to claim 1, wherein the navigation aid management module (7) is configured to add, edit and delete navigation aids by way of storing, correcting and deleting navigation aid properties through the database module (3); and
wherein, optionally, the navigation aid properties are practical navigation aids' property values by kinds, such as the total size of a navigation aid, and sizes and colors, attenuation rates, flickering periods, of lanterns.

11. The simulator system according to claim 1, wherein the navigation aid management module (7) is configured to position a navigation aid on an electronic nautical chart or a nautical chart, which is made based on the electronic chart, through the virtual three-dimensional reproduction module (4) in embodying navigation aid disposition.

12. The simulator system according to claim 11, wherein the navigation aid management module (7) is configured to conduct a virtual shipping function with a virtual ship anytime while disposing a navigation aid, enabling qualitative verification for shipping safety of ships in accordance with navigation aid disposition results; and/or
wherein the navigation aid management module (7) is configured to output catalogues and nautical charts for the navigation aid disposition results.

13. The simulator system according to claim 1, wherein the navigation aid analysis module is further configured to quantify optimized disposition points by navigation aids with accumulation for different virtual shipping courses in analyzing the coursed disposition results.

14. The simulator system according to any of claims 1 through 13, wherein the simulation control module is configured to newly set a location and course of a ship before or during the simulation.

15. The simulator system according to any of claims 1 through 13, wherein the simulation control module (1) is configured to set a ship velocity higher or lower than a practical one before or during the simulation.

## Patentansprüche

1. Simulatorsystem zum Bestimmen optimaler. Positionen von Navigationshilfen für Schiffe, das es ermöglicht, eine Navigationshilfe in einem virtuellen Raum, der unter den gleichen Bedingungen wie ein wirklicher Meeresbereich wiedergegeben wird, bevor die Navigationshilfe in dem wirklichen Meeresbereich installiert wird, im Voraus frei anzuordnen, indem eine Simulationstechnologie verwendet wird, wobei das Simulatorsystem Folgendes umfasst:
ein Simulationssteuermodul (1), das konfiguriert ist, um die allgemeine Verwaltung der Vorbereitung, des Beginns, der Regulierung und der Beendigung der Simulation auszuführen;
ein Modul (2) zum Wiedergeben eines Schiffs/Meers, das konfiguriert ist, um die nächsten Zustandswerte aus aktuellen Zustandswerten, die Informationen über Schiffsstandorte und Wellenhöhen umfassen, die von dem Simulationssteuermodul (1) bereitgestellt werden, zu berechnen und ein Ergebnis der Berechnung an das Simulationssteuermodul (1) zurückzugeben;
ein Datenbankmodul (3), das konfiguriert ist, um Informationen über Schiffe und Meeresbereiche, Formen und Kennzeichen von Navigationshilfen und Simulationsausführungen zu speichern;
ein Modul (4) zur virtuellen dreidimensionalen Wiedergabe, das konfiguriert ist, um Informationen über Schiffe, Umgebungen, Wetterverhältnisse und Uhrzeit zu zeigen, die von dem Simulationssteuermodul (1) bereitgestellt werden;
ein Modul (5) zum Wiedergeben einer Kommandobrücke, das konfiguriert ist, um Kennzeichen von Führung, Maschinentelegraf, Radar und Transport wiederzugeben;
ein Tonwiedergabemodul (6), das konfiguriert ist, um Ton aus Informationen über die Toneffektwiedergabe, die von dem Simulationssteuermodul (1) bereitgestellt wird, wiederzugeben;
ein Navigationshilfen-Verwaltungsmodul (7), das konfiguriert ist, um eine Navigationshilfe in der Simulation hinzuzufügen, zu bearbeiten, zu löschen und anzuordnen; und
ein Navigationshilfen-Analysemodul (8), das konfiguriert ist, um die Ergebnisse der Anordnung von Navigationshilfen nach Standorten als Funktion einer Analyse der positionsmäßigen Anordnungsergebnisse oder nach Kursen als Funktion einer Analyse der geplanten Anordnungsergebnisse zu quantifizieren,
wobei das Navigationshilfen-Analysemodul konfiguriert ist, um optimierte Anordnungspunkte für Navigationshilfen an aktuellen Schiffsstandorten während eines virtuellen Transportvorgangs beim Analysieren der positionsmäßigen Anordnungsergebnisse zu quantifizieren, und/oder
wobei das Navigationshilfen-Analysemodul konfiguriert ist, um optimierte Anordnungspunkte nach Navigationshilfen für entsprechende virtuelle Transportkurse nach einem virtuellen Transportvorgang beim Analysieren der geplanten Anordnungsergebnisse zu quantifizieren, und
wobei das Navigationshilfen-Analysemodul konfiguriert ist, um die optimierten Anordnungspunkte nach Navigationshilfen, die quantifiziert sind, an das Navigationshilfen-Verwaltungsmodul zu übertragen, wodurch das Navigationshilfen-Verwaltungsmodul die optimierten Anordnungspunkte beim Bestimmen einer optimalen Position für eine Navigationshilfe verwenden kann.

2. Simulatorsystem nach Anspruch 1, wobei das Simulationssteuermodul (1) konfiguriert ist, um anfängliche Standorte und Transportkurse von virtuellen Schiffen beim Ausführen der Vorbereitung der Simulation einzustellen.

3. Simulatorsystem nach Anspruch 1, wobei das Simulationssteuermodul (1) konfiguriert ist, um einen Meeresbereich für die Anordnung von Navigationshilfen und ein Schiff, das für die Überprüfung zu verwenden ist, auszuwählen und um anfängliche Umgebungsbedingungen, wie etwa Wind und Wellen, Wetterverhältnisse und Uhrzeit, zu Beginn der Simulation einzustellen; und/oder
wobei das Simulationssteuermodul (1) konfiguriert ist, um einen globalen Transportzustand des Schiffs zu regulieren, während dessen das Simulationssteuermodul (1) Steuervorgänge des Überwachens und Regulierens von Umgebungsinformationen, wie etwa Wind und Wellen, wechselnde Wetterverhältnisse und Uhrzeit und des Anpassens der Zustände von Antrieb und Führung beim Steuern der Simulation ausführt.

4. Simulatorsystem nach Anspruch 1, wobei das Simulationssteuermodul (1) konfiguriert ist, um Informationen, welche die Ausführung der Simulation bis zur Beendigung betreffen, an das Datenbankmodul (3) zu übertragen, damit die Informationen in dem Datenbankmodul (3) beim Beenden der Simulation aufgezeichnet werden; und
wobei das Datenbankmodul (3) wahlweise konfiguriert ist, um Informationen über den Transportvorgang eines Schiffs, die Umgebungen eines angestrebten Meeresbereichs, das Wetter und die Uhrzeit und eine quantitative Analyse für Navigationshilfen zu speichern.

5. Simulatorsystem nach Anspruch 1, wobei das Simulationssteuermodul (1) konfiguriert ist, um aktuelle Zustandswerte, wie etwa Schiffsstandorte und Wellenhöhen, an das Modul (2) zum Wiedergeben eines Schiffs/Meers zu übertragen, um die nächsten Zustandswerte von dem Modul (2) zum Wiedergeben eines Schiffs/Meers zu empfangen und zu speichern, und um dann die nächsten Zustandswerte an das Modul (4) zur virtuellen dreidimensionalen Wiedergabe, das Modul (5) zum Wiedergeben einer Kommandobrücke und das Tonwiedergabemodul (6) zu übertragen, damit die Simulation synchron aktiviert werden kann.

6. Simulatorsystem nach Anspruch 1, wobei das Modul (2) zum Wiedergeben eines Schiffs/Meers konfiguriert ist, um Schiffsdimensionsdaten über Länge, Breite und Tiefgang eines Schiffs aus dem Datenbankmodul (3) aufzurufen, um Schiffsbewegungskennzeichen beim Berechnen der nächsten Zustandswerte an das Simulationssteuermodul (1) nach dem Empfang der aktuellen Zustandswerte, wie etwa Schiffsstandorte und Wellenhöhen von dem Simulationssteuermodul (1), wiederzugeben.

7. Simulatorsystem nach Anspruch 1, wobei das Datenbankmodul (3) konfiguriert ist, um verteilt mit einer Vielzahl von Datenbanken gemäß einer Art von Informationen, die in dem Datenbankmodul (3) gespeichert sind, zu arbeiten; und
wobei das Datenbankmodul (3) wahlweise konfiguriert ist, um verteilt als Situationsdatenbank, die Situationen für die Simulation speichert, als Meeresbereichszustands-Datenbank, die Zustände von Meeresbereichen speichert, in denen virtuelle Schiffe fahren, als Meeresbereichsform-Datenbank, die Formen von Meeresbereichen speichert, in denen virtuelle Schiffe fahren, als Schiffsbewegungskennzeichen-Datenbank, die Bewegungskennzeichen speichert, während die virtuellen Schiffe fahren, als Schiffsform-Datenbank, die Formen von virtuellen Schiffen speichert, als Navigationshilfeneigenschafts-Datenbank, die Eigenschaften von Navigationshilfen speichert, und als Navigationshilfenmuster-Datenbank, die Muster von Navigationshilfen speichert, zu arbeiten.

8. Simulatorsystem nach Anspruch 1, wobei das Modul (4) zur virtuellen dreidimensionalen Wiedergabe konfiguriert ist, um sichtbar Informationen über Formen von Meeresbereichen und Schiffen und Eigenschaften von Navigationshilfen, die von dem Datenbankmodul (3) empfangen werden, zusammen mit Informationen über die Anordnung von Navigationshilfen, die von dem Modul (7) zum Verwalten von Navigationshilfen empfangen werden, zu zeigen, indem es Informationen über Schiffe und Umgebungen, Wetterverhältnisse und Uhrzeit, die von dem Simulationssteuermodul (1) bereitgestellt werden, sichtbar zeigt.

9. Simulatorsystem nach Anspruch 1, wobei das Modul (5) zum Wiedergeben einer Kommandobrücke konfiguriert ist, um eine Schiffskommandobrücke nach dem Empfang von Informationen, die notwendig sind, um inhärente Funktionen der Führung, des Maschinentelegrafs, des Radars, der Anzeige von Navigationsinformationen wiederzugeben, zu emulieren; und
wobei das Modul (5) zum Wiedergeben einer Kommandobrücke wahlweise konfiguriert ist, um Führungsanweisungswerte, die auf die Führung angewendet werden, und Maschinenanweisungswerte, die auf den Maschinentelegraf angewendet werden, an das Simulationssteuermodul (1) zu übertragen.

10. Simulatorsystem nach Anspruch 1, wobei das Modul (7) zum Verwalten von Navigationshilfen konfiguriert ist, um Navigationshilfen anhand des Speicherns, Korrigierens und Löschens der Eigenschaften von Navigationshilfen durch das Datenbankmodul (3) hinzuzufügen, zu bearbeiten und zu löschen; und
wobei die Eigenschaften von Navigationshilfen wahlweise praktische Eigenschaftswerte der Navigationshilfen nach Arten, wie etwa Gesamtgröße einer Navigationshilfe und Größe und Farben, Abschwächungsraten, Blinkperioden von Lampen, sind.

11. Simulatorsystem nach Anspruch 1, wobei das Modul (7) zum Verwalten von Navigationshilfen konfiguriert ist, um eine Navigationshilfe auf einer elektronischen Seekarte oder einer Seekarte, die basierend auf der elektronischen Karte erstellt wird, durch das Modul (4) zur virtuellen dreidimensionalen Wiedergabe beim Ausbilden der Anordnung von Navigationshilfen zu positionieren.

12. Simulatorsystem nach Anspruch 11, wobei das Modul (7) zum Verwalten von Navigationshilfen konfiguriert ist, um eine virtuelle Transportfunktion mit einem virtuellen Schiff jederzeit während des Anordnens einer Navigationshilfe vorzunehmen, was eine qualitative Überprüfung für die Transportsicherheit der Schiffe gemäß den Ergebnissen der Anordnung von Navigationshilfen ermöglicht; und/oder
wobei das Modul (7) zum Verwalten von Navigationshilfen konfiguriert ist, um Kataloge und Seekarten für die Ergebnisse der Anordnung von Navigationshilfen auszugeben.

13. Simulatorsystem nach Anspruch 1, wobei das Navigationshilfen-Analysemodul ferner konfiguriert ist, um optimierte Anordnungspunkte durch Navigationshilfen mit Häufung für verschiedene virtuelle Transportkurse beim Analysieren der geplanten Anordnungsergebnisse zu quantifizieren.

14. Simulatorsystem nach einem der Ansprüche 1 bis 13, wobei das Simulationssteuermodul konfiguriert ist, um einen Standort und Kurs eines Schiffs vor oder während der Simulation erneut einzustellen.

15. Simulatorsystem nach einem der Ansprüche 1 bis 13, wobei das Simulationssteuermodul (1) konfiguriert ist, um eine Schiffsgeschwindigkeit vor oder während der Simulation höher oder niedriger als eine geeignete einzustellen.

## Revendications

1. Système de simulateur permettant de déterminer des positions optimales d'aides à la navigation de bateaux, permettant à une aide à la navigation d'être disposée librement à l'avance dans un espace virtuel reproduit dans la même condition qu'une zone maritime réelle, avant d'installer l'aide à la navigation dans la zone maritime réelle, par l'utilisation d'une technologie de simulation, le système de simulateur comprenant :
un module de contrôle de simulation (1) conçu pour exécuter une gestion générale sur la préparation, le début, la régulation et l'achèvement de la simulation ;
un module de reproduction de mer/de bateau (2) conçu pour calculer les prochaines valeurs d'état à partir des valeurs d'état actuelles, qui comprennent des informations concernant des localisations du bateau et de hauteur des vagues, venant du module de commande de simulation (1), et retournent un résultat du calcul au module de commande de simulation (1) ;
un module de base de données (3) conçu pour stocker des informations concernant des bateaux et des zones maritimes, des caractéristiques et des formes d'aide à la navigation, et des exécutions de simulation ;
un module de reproduction tridimensionnelle virtuelle (4), conçu pour montrer des informations concernant des bateaux, des environnements, des conditions météo et le temps, qui vient du module de commande de simulation (1) ;
un module de reproduction de pont (5) conçu pour reproduire une manoeuvre, un moteur télégraphique, un radar et des caractéristiques d'expédition ;
un module de reproduction sonore (6) conçu pour reproduire du son à partir d'informations concernant la reproduction d'effets sonores qui vient du module de commande de simulation (1) ;
un module de gestion d'aide à la navigation (7) conçu pour ajouter, éditer, effacer et disposer une aide à la navigation dans la simulation ; et
un module d'analyse d'aide à la navigation (8) conçu pour quantifier les résultats de disposition d'aide à la navigation par des localisations, en tant que fonction d'analyse de résultats de disposition de position, ou par des parcours, en tant que fonction d'analyse de résultats de disposition parcourus,
dans lequel le module d'analyse d'aide à la navigation est conçu pour quantifier des points de disposition optimisée d'aides à la navigation à des localisations de bateaux actuelles pendant une opération d'expédition virtuelle dans l'analyse des résultats de disposition de position, et/ou
dans lequel le module d'analyse d'aide à la navigation est conçu pour quantifier des points de disposition optimisée par des aides à la navigation pour des parcours d'expédition virtuels correspondants, après une opération d'expédition virtuelle, dans l'analyse des résultats de disposition parcourus, et
dans lequel le module d'analyse d'aide à la navigation est conçu pour transférer les points de disposition optimisée par des aides à la navigation, qui sont quantifiés, au module de gestion d'aide à la navigation, ce qui permet au module de gestion d'aide à la navigation d'utiliser les points de disposition optimisée pour déterminer une position optimale d'une aide à la navigation.

2. Système de simulateur selon la revendication 1, dans lequel le module de commande de simulation (1) est conçu pour définir des localisations initiales et des parcours d'expédition de bateaux virtuels lorsqu'il exécute la préparation de la simulation.

3. Système de simulateur selon la revendication 1, dans lequel le module de commande de simulation (1) est conçu pour sélectionner une zone maritime de disposition d'aide à la navigation et un bateau à utiliser pour une vérification, et pour définir des conditions environnementales initiales telles que les vents et les vagues, les conditions météo, et le temps au début de la simulation ; et/ou
dans lequel le module de commande de simulation (1) est conçu pour réguler un état d'expédition global du bateau, pendant lequel le module de commande de simulation (1) exécute des opérations de commande de surveillance et de régulation des informations environnementales comme les vents et les vagues, le changement des conditions météo et du temps, et le réglage des états de propulsion et de manoeuvre, lors du contrôle de la simulation.

4. Système de simulateur selon la revendication 1, dans lequel le module de commande de simulation (1) est conçu pour transférer des informations, qui sont impliquées dans l'exécution de la simulation jusqu'à l'achèvement, au module de base de données (3) de sorte que les informations sont enregistrées dans le module de base de données (3) à l'achèvement de la simulation ; et
dans lequel, facultativement, le module de base de données (3) est conçu pour stocker des informations concernant une opération d'expédition d'un bateau, des environnements d'une zone maritime cible, la météo et le temps, et une analyse quantitative des aides à la navigation.

5. Système de simulateur selon la revendication 1, dans lequel le module de commande de simulation (1) est conçu pour transférer des valeurs d'état actuel, telles que les localisations des bateaux et les hauteurs de vagues, au module de reproduction de mer/de bateau (2), pour recevoir et stocker les prochaines valeurs d'état provenant du module de reproduction de mer/de bateau (2), et ensuite pour transférer les prochaines valeurs d'état au module de reproduction tridimensionnelle virtuelle (4), au module de reproduction de pont (5) et au module de reproduction sonore (6) de manière à permettre à la simulation d'être activée avec une synchronisation.

6. Système de simulateur selon la revendication 1, dans lequel le module de reproduction de mer/de bateau (2) est conçu pour demander des données de dimensions du bateau concernant la longueur, la largeur, l'ébauche d'un bateau à partir du module de base de données (3), pour reproduire des caractéristiques de mouvement du bateau, lors du calcul des prochaines valeurs d'état vers le module de commande de simulation (1) après la réception des valeurs d'état actuelles, telles que des localisations du bateau et des hauteurs de vagues, provenant du module de commande de simulation (1).

7. Système de simulateur selon la revendication 1, dans lequel le module de base de données (3) est conçu pour fonctionner de manière divisée avec une multiplicité de bases de données en fonction d'un type d'informations stocké dans le module de base de données (3) ; et
dans lequel, facultativement, le module de base de données (3) est conçu pour fonctionner de manière divisée en tant que base de données de scénario stockant des scénarios pour la simulation, une base de données d'état d'une zone maritime stockant des états de zones maritimes où fonctionnent des bateaux virtuels, une base de données de forme de zone maritime stockant des formes de zones maritimes où fonctionnent des bateaux virtuels, une base de données de caractéristiques de mouvements de bateaux stockant des caractéristiques de mouvements pendant que des bateaux virtuels fonctionnent, une base de données de formes de bateaux stockant des formes de bateaux virtuels, une base de données de propriétés d'aide à la navigation stockant des propriétés d'aides à la navigation et une base de données de motifs d'aides à la navigation stockant des motifs d'aides à la navigation.

8. Système de simulateur selon la revendication 1, dans lequel le module de reproduction tridimensionnelle virtuelle (4) est conçu pour montrer de manière visible les informations concernant les formes des zones maritimes et des bateaux, et des propriétés d'aides à la navigation, qui sont reçues en provenance du module de base de données (3), avec des informations concernant une disposition d'aide à la navigation qui sont reçues en provenance du module de gestion d'aide à la navigation (7), en montrant de manière visible des informations concernant des bateaux et des environnements, des conditions météo et le temps qui viennent du module de commande de simulation (1).

9. Système de simulateur selon la revendication 1, dans lequel le module de reproduction de pont (5) est conçu pour émuler un pont de bateau après réception des informations nécessaires pour reproduire des fonctions inhérentes de manoeuvre, de moteur télégraphique, de radar, d'affichage des informations d'expédition ; et
dans lequel, facultativement, le module de reproduction de pont (5) est conçu pour transférer des valeurs d'instruction de manoeuvre appliquées à la manoeuvre, et des valeurs d'instruction de moteur appliquées au moteur télégraphique vers le module de commande de simulation (1).

10. Système de simulateur selon la revendication 1, dans lequel le module de gestion d'aide à la navigation (7) est conçu pour ajouter, éditer et effacer des aides à la navigation au moyen d'un stockage, d'une correction et d'un effacement des propriétés d'aide à la navigation par le biais du module de base de données (3) ; et
dans lequel, facultativement, les propriétés d'aide à la navigation sont des valeurs de propriétés d'aides à la navigation pratiques par genres, telles que la taille totale d'une aide à la navigation, et des tailles et des couleurs, des taux d'atténuation, des périodes de scintillement, de lanternes.

11. Système de simulateur selon la revendication 1, dans lequel le module de gestion d'aide à la navigation (7) est conçu pour positionner une aide à la navigation sur une charte nautique électronique ou une charte nautique, qui est faite sur la base de la charte électronique, par le biais du module de reproduction tridimensionnelle virtuelle (4) lors de la mise en oeuvre d'une disposition d'aide à la navigation.

12. Système de simulateur selon la revendication 11, dans lequel le module de gestion d'aide à la navigation (7) est conçu pour mener une fonction d'expédition virtuelle avec un bateau virtuel à n'importe quel moment tout en disposant d'une aide à la navigation, ce qui permet une vérification qualitative de la sécurité d'expédition des bateaux en fonction des résultats de disposition d'aide à la navigation ; et/ou
dans lequel le module de gestion d'aide à la navigation (7) est conçu pour émettre des catalogues et des chartes nautiques concernant les résultats de disposition d'aide à la navigation.

13. Système de simulateur selon la revendication 1, dans lequel le module d'analyse d'aide à la navigation est conçu en outre pour quantifier des points de disposition optimisée par des aides à la navigation avec une accumulation pour différents parcours d'expédition virtuelle dans l'analyse des résultats de disposition parcourus.

14. Système de simulateur selon l'une quelconque des revendications 1 à 13, dans lequel le module de contrôle de simulation est conçu pour définir à nouveau une localisation et un parcours d'un bateau avant ou pendant la simulation.

15. Système de simulateur selon l'une quelconque des revendications 1 à 13, dans lequel le module de contrôle de simulation (1) est conçu pour régler une vitesse du bateau supérieure ou inférieure à une vitesse pratique avant ou pendant la simulation.
